# EUROPEAN PATENT SPECIFICATION

(11) **EP 2 524 978 B1**
(45) Date of publication and mention of the grant of the patent: **07.01.2015**
(21) Application number: 11732944.1
(22) Date of filing: 14.01.2011
(51) Int. Cl.: C30B 29/36, C30B 23/06, C30B 23/00

(54) **APPARATUS FOR PRODUCING SILICON CARBIDE SINGLE CRYSTAL**
VORRICHTUNG ZUR HERSTELLUNG EINES SILIZIUMCARBID-EINKRISTALLS
APPAREIL POUR LA PRODUCTION D'UN MONOCRISTAL DE CARBURE DE SILICIUM

(30) Priority: 15.01.2010 JP 2010006982
(43) Date of publication of application: 21.11.2012
(73) Proprietor: Bridgestone Corporation, Tokyo 104-8340 (JP)
(72) Inventor: SEKI, Wataru, Tokyo 187-8531 (JP); KONDO, Daisuke, Tokyo 187-8531 (JP)
(74) Representative: Oxley, Robin John George
(86) International application number: PCT/JP2011/050504
(87) International publication number: WO 2011/087074

(56) References cited:
- JP-A- 11 278 985
- JP-A- 2001 072 490
- JP-A- 2002 308 699
- JP-A- 2006 290 685
- JP-A- 2008 504 203
- US-A1- 2005 126 471
- US-A1- 2005 166 833

## Description

### TECHNICAL FIELD

The present invention relates to an apparatus for producing silicon carbide single crystal for producing a silicon carbide single crystal using the improved Rayleigh method (sublimation method)

### BACKGROUND ART

Compared to silicon, silicon carbide has a large band gap and is excellent in its breakdown characteristic, resistance to heat, and resistance to radiation. For these reasons, silicon carbide has been drawing attention as a material for electronic devices such as a small-sized semiconductor wafer with high output and for optical devices such as a light-emitting diode. In the fields of such electronic devices and optical devices, there are demands for a high-quality silicon carbide single crystal having fewer defects such as an interfusion of polycrystal and polymorphism, and pipe-shaped crystal defects (so-called micro-pipes).

To answer such demands, a method has been disclosed in which a silicon carbide single crystal is grown while keeping its entire growth face having an almost-spherical, projecting shape (see Patent Document 1). In this method, in order for silicon carbide to be easily recrystallized on a seed crystal, the temperature gradient for the seed crystal is set such that the temperature of the seed crystal, which is low at its center portion, becomes higher toward the peripheral portion from the center portion.

In this method, since silicon carbide is recrystallized more in the center portion of the seed crystal than elsewhere, a silicon carbide single crystal can be grown while keeping the projecting shape. Accordingly, a high-quality silicon carbide single crystal with fewer faults can be produced.

The above method, however, has a problem in giving a silicon carbide single crystal wafer a large diameter, which is demanded in recent years. Specifically, a seed crystal with a large diameter is used in order to provide a large diameter to the silicon carbide single crystal. However, the temperature is higher at a position more distant away in the radial direction of the seed crystal from the center of the mounting face onto which the seed crystal is arranged. Consequently, increasing the diameter of the seed crystal might cause the temperature difference between a center portion of the seed crystal and a peripheral portion thereof which is away from the center portion to exceed an acceptable value for maintaining the quality of the silicon carbide single crystal.

In order for the temperature difference between the center portion and the peripheral portion of the seed crystal not to exceed the acceptable value, the temperature gradient should be decreased. However, in order for the silicon carbide single crystal to grow while keeping its growth face having an almost-spherical, protruding shape, the peripheral portion of the crystal has to have a temperature gradient of, for example, at least about 1°C/cm.

As described above, it is difficult to meet both the condition for the temperature difference between the center portion and the peripheral portion of the seed crystal and the condition for the temperature gradient, the conditions being for producing a high-quality silicon carbide single crystal. Accordingly, it is difficult to produce a large-diameter silicon carbide single crystal using the technique disclosed in Patent Document 1.

### PRIOR ART DOCUMENTS

### PATENT DOCUMENTS

Patent Document 1: Japanese Patent Application Publication No. 2002-308699;
Patent Document 2: US 2005/0126471.

### SUMMARY OF THE INVENTION

An apparatus for producing a silicon carbide single crystal (an apparatus 1 for producing a silicon carbide single crystal) according to the one characteristic includes a crucible (a crucible 2) configured to house a seed crystal (a seed crystal 11) containing silicon carbide and a raw material for sublimation (a raw material for sublimation 10) arranged opposite the seed crystal and used for growing the seed crystal. The crucible comprises a crucible body (a crucible body 7) configured to house the raw material for sublimation, and a lid (a lid 8, 30) configured such that the seed crystal is arranged on the lid. A thickness (a thickness T1, T3) of the lid at a center area thereof corresponding to a radial center portion of the seed crystal is larger than a thickness (a thickness T2, T4) of the lid at a peripheral area thereof corresponding to a portion located radially outside the radial center portion of the seed crystal, the lid having a peak portion (18) corresponding to the radial center portion of the seed crystal (11) and inclines downwardly from the peak portion (18) towards the peripheral area thereof.

According to this, when the crucible is heated, the temperature difference between the center area and the peripheral area of the lid is decreased. Accordingly, in production of a large-diameter silicon carbide single crystal, a high-quality silicon carbide single crystal keeping an almost spherical shape can be grown. A description is given below more specifically.

To reduce the temperature difference between the radial center and the radial outer portion of the lid 8, 30, the temperature gradient should be reduced by using a thick lid. However, in such a case, the temperature gradient at the peripheral portion of the crystal might reach or fall below the lowest value of the temperature gradient for growing a spherical single crystal. Further, it is preferable in growing crystals that the radial center portion (i.e., the center area) of the seed crystal 11 have a smaller temperature gradient than the circumferential portion (i.e., the peripheral area) thereof. For these reasons, it is the gist of the present invention that the thickness of the lid at the portion corresponding to the center area of the seed crystal is formed to be larger than the thickness of the lid at the portion corresponding to the peripheral area of the seed crystal so as to provide a small temperature gradient at the radial center portion of the lid and a large temperature gradient at the radial outer portion thereof.

In the one characteristic, in an outer surface (a surface 17) of the lid (the lid 8, 30), an outer surface of the lid at the center area protrudes more to the outside of the crucible (the crucible 2) than an outer surface thereof at the peripheral area.

In the one characteristic, a heat shield is arranged in accordance with a protruding surface of the lid.

In the one characteristic, an attachment portion (an attachment portion 15) configured such that the seed crystal (the seed crystal 11) is attached on the attachment portion is arranged on an inner side of the lid (the lid 8), and the sum of the thickness of the lid at the center area and the thickness of the attachment portion is larger than the sum of the thickness of the lid at a portion corresponding to the peripheral area and the thickness of the attachment portion.

### BRIEF DESCRIPTION OF THE DRAWING(S)

[Fig. 1] Fig. 1 is a cross-sectional overall view of an apparatus for producing a silicon carbide single crystal according to an embodiment of the present invention.
[Fig. 2] Fig. 2 is an enlarged cross-sectional view showing the lid in Fig. 1.
[Fig. 3] Fig. 3 is an enlarged cross-sectional view of a lid according to a modification of the present invention.
[Fig. 4] Fig. 4 is a cross-sectional view showing how heat travels from a heating coil toward a crucible, the crucible employing a conventional shape.
[Fig. 5] Fig. 5 is an enlarged view showing isothermal lines in a vicinity portion of an attachment portion for a seed crystal in Fig. 4.
[Fig. 6] Fig. 6 (a) is a schematic view showing isothermal lines for a thin lid, and Fig. 6(b) is a schematic view showing isothermal lines for a thick lid.
[Fig. 7] Fig. 7 is a schematic view showing isothermal lines for the lid according to the embodiment of the present invention.

### MODES FOR CARRYING OUT THE INVENTION

An apparatus for producing a silicon carbide single crystal according to an embodiment of the present invention will be described in detail below with reference to the drawings. Specifically, descriptions will be given as to (1) the overall configuration of the apparatus for producing a silicon carbide single crystal, (2) the detailed configurations of a lid and a heat shield, (3) a modification, (4) heat conduction in the apparatus for producing a silicon carbide single crystal according to the present invention, (5) advantageous effects, and (6) other embodiments.

Note that the drawings are only schematic, and the thicknesses of the materials and their ratios are different from the actual values. Accordingly, specific thicknesses and dimensions should be determined based on the description given below. Moreover, the drawings also include portions having different dimensional relationships and ratios from each other.

### (1) Overall Configuration of Apparatus for Producing Silicon Carbide Single Crystal

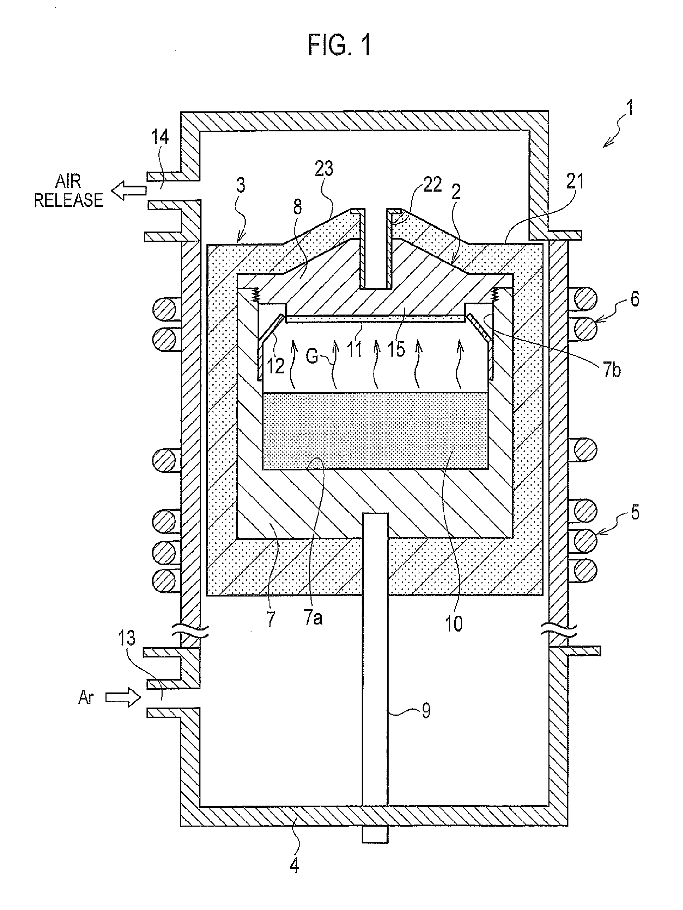

First, the overall configuration of the apparatus 1 for producing a silicon carbide single crystal is described using Fig. 1. Fig. 1 is a cross-sectional view showing the apparatus 1 for producing a silicon carbide single crystal according to the embodiment of the present invention.

An apparatus 1 for producing a silicon carbide single crystal includes a graphite crucible 2, a heat shield 3 surrounding the circumference of the crucible 2, a quartz pipe 4 configured to house the crucible 2 and the heat shield 3, and dielectric heating coils 5, 6 arranged around the circumference of the quartz pipe 4.

The crucible 2 includes a crucible body 7 and a lid 8, and is placed inside the quartz pipe 4 by being moved by a support rod 9. A raw material for sublimation 10 which is powder containing silicon carbide is housed in a bottom portion 7a of the crucible body 7. This raw material for sublimation 10 is arranged opposite a seed crystal 11 supported on the lid 8. A guide member 12 of a substantial tubular shape extends from the vicinity of the circumference of the lid 8 to the inner surface of the crucible body 7. Moreover, the side surface of the quartz pipe 4 has an inlet for argon gas 13 through which argon gas (Ar gas) is inputted and an outlet 14 through which gas inside the quartz pipe 4 is released to the outside. The lid 8 plugs an upper opening 7b of the reaction container body 7, and detachably screwed onto the inner surface of an upper end portion of the reaction container body 7. Further, the seed crystal 11 containing silicon carbide is attached to the bottom surface of the lid 8 via an attachment portion 15. Means for supporting the seed crystal 11 may be adhesive bonding or mechanical bonding using screws or the like.

The raw material for sublimation 10 is a powder silicon carbide raw material containing silicon carbide. The raw material for sublimation 10 sublimes and becomes sublimed gas G when the inside of the crucible 2 reaches predetermined temperature and pressure conditions, and is re-crystallized and grown on the seed crystal 11. Thereby, a silicon carbide single crystal is formed.

The dielectric heating coils include a first induction heating coil 5 arranged at a height corresponding to the lower portion of the crucible body 7 and a second induction heating coil 6 arranged at a height corresponding to the seed crystal 11 supported on the bottom surface of the lid 8.

### (2) Detailed Configurations of Lid and Heat Shield

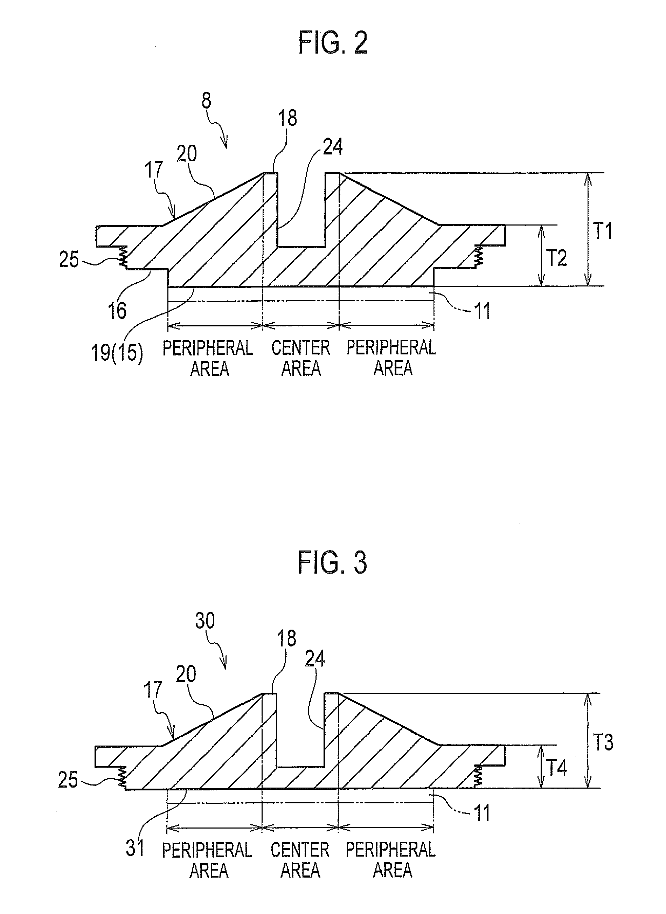

Next, the configuration of the lid 8 according to the present embodiment is described using Fig. 2. Fig. 2 is an enlarged cross-sectional view showing the lid 8 in Fig. 1.

The bottom surface of the lid 8 (i.e., the inner surface of the crucible 2) has a lower surface 16 formed in a circumferential portion and the attachment portion 15 for seed crystal 11, protruding downward from the lower surface 16 and having a disc shape.

In a surface 17 of the lid 8 on the upper side thereof (i.e., the outside of the crucible 2), a portion corresponding to a center area which is a radial-center portion of the attachment portion 15 supporting the seed crystal 11 protrudes upward to form a peak portion 18. The upper surface 17 of the lid 8 is formed into a substantial triangular shape when viewed from the side. In addition, a thickness T1 of the lid 8 at a portion corresponding to the center area mentioned above is the vertical dimensional difference between the peak portion 18 and a bottom surface 19 of the attachment portion 15. In other words, this thickness T1 is the total of the thickness of the lid at the portion corresponding to the center area and the thickness of the attachment portion 15.

Moreover, in the surface 17 of the lid 8 on the upper side thereof (i.e., the outside of the crucible 2), a peripheral area located radially outside the center area is formed into an inclined surface 20 inclined downward (i.e., toward the inside of the crucible 2) toward the circumference. Accordingly, the thickness T1 of the portion corresponding to the center area is formed to be larger than the thickness of the lid 8 at the portion corresponding to the peripheral area. For example, the thickness T1 is formed to be larger than a thickness T2 at a circumference edge portion of the peripheral area. The thickness of the lid 8 at the portion corresponding to the peripheral area is also the total of the thickness of the lid itself and the thickness of the attachment portion 15. Note that a measurement hole 24 for temperature measurement, which is depressed downward, is formed in the peak portion 18, and a screw portion 25 engaging the crucible body 7 is provided to the circumferential edge of the lid 8.

In addition, as shown in Fig. 1 described above, the heat shield 3 according to the present embodiment is arranged to surround the crucible 2 from outside. A top surface 21 of the heat shield 3 is formed in accordance with the shape of the lid 8 so as to be in contact with the protruding upper surface of the lid 8. Specifically, a radial center portion of the heat shield 3 is formed into a peak portion 22 protruding upward (i.e., to the outside of the crucible 2), and into an inclined surface 23 inclined, straight in cross section, downward from the peak portion 22 toward the circumference.

### (3) Modification

Next, a modification of the present invention will be described using Fig. 3. Portions having the same structures as those of the embodiment described above are given the same reference numerals, and are not described again. Fig. 3 is an enlarged cross-sectional view of a lid of the modification of the present invention.

A lid 30 has a shape obtained by excluding the attachment portion 15 from the lid 8 of Fig. 2 described above. Specifically, a bottom surface 31 of the lid 30 has a single flat surface in which the attachment portion 15 protruding downward as shown in Fig. 2 is not provided at the radial center portion of the bottom surface. It is configured such that the seed crystal 11 can be attached to the bottom surface 31.

In the lid 30 of this modification, a lid thickness T3 is the vertical dimension between the bottom surface 31 and an outer portion of the peak portion 18 of the lid 30 in its center area corresponding to the radial center portion of the seed crystal 11. On the other hand, the thickness of the lid 30 at the peripheral area located on the circumferential side of the center area is set to be smaller than the thickness T3. The thickness of the lid 30 at the circumferential edge of the peripheral area is T4 for example, and the T3 is formed to be thicker than the T4.

### (4) Heat Conduction in Apparatus for Producing Silicon Carbide Single Crystal according to Present Invention

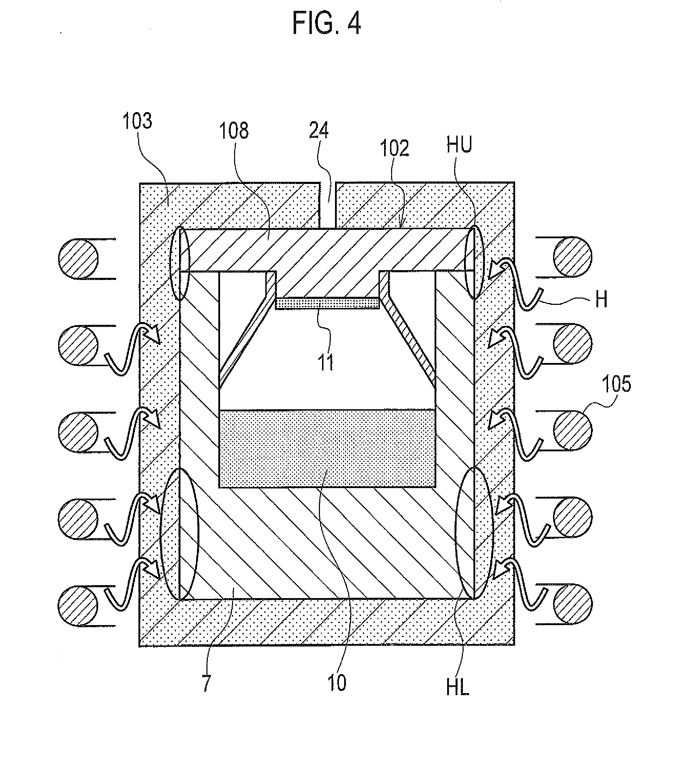

Next, using Figs. 4 to 7, a description will be given for heat conduction in the apparatus 1 for producing a silicon carbide single crystal according to the present invention.

Fig. 4 is a cross-sectional view showing how heat travels from the heating coil 105 toward the crucible 2. It should be noted that a crucible 102 employs a conventional shape for convenience. Accordingly, the surface of a lid 108 of the crucible 102 on the upper side (i.e., the outside of the crucible 102) is formed to be flat, the radial center portion of which does not protrude upward as in the lid 108 according to the above embodiment.

When current is applied to, and thereby heats up, the induction heating coil 105, this induction heating (heat H) heats up a circumferential portion (i.e., a peripheral portion) of the crucible 102. To efficiently grow a single crystal from the seed crystal 11, the raw material for sublimation 10 should keep having a higher temperature than the seed crystal 11. Therefore, a heating amount H_{L} for the lower portion of the crucible 102 is larger than a heating amount H_{U} for the upper portion thereof.

As shown in Fig. 4 (or Fig. 3), a temperature measurement hole 24 is formed in a center portion of the lid 108, extending downward from the top side. Accordingly, heat conducted to the upper portion of the crucible 102 travels toward the radial center of the lid 108.

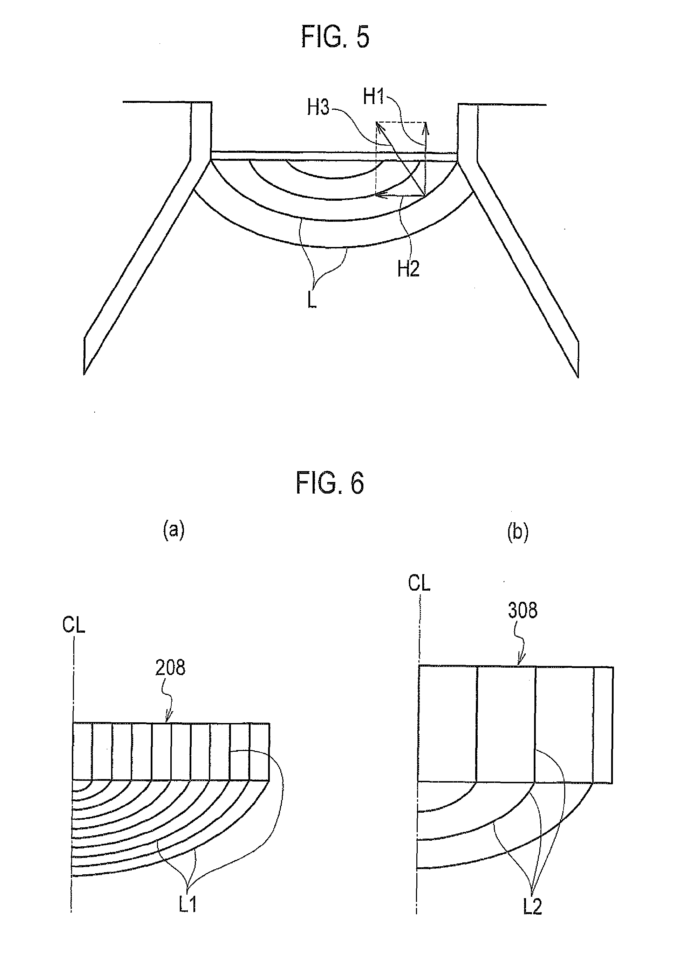

Then, as Fig. 5 shows, a heat H1 flowing upward from below is combined with a heat H2 flowing radially inward from the radial outer side to become a heat H3 flowing obliquely upward. Since the heat flow H3 is orthogonal to isothermal lines L, isothermal lines in the bottom surface of the lid are as shown in Fig. 5.

Next, a comparison in isothermal lines is made between a thin lid and a thick lid, in both cases the thickness of the lid being constant in the radial direction. Fig. 6 (a) is a schematic diagram showing isothermal lines of a thin lid 208, and Fig. 6 (b) is a schematic diagram showing isothermal lines of a thick lid 308.

Fig. 6(a) shows dense isothermal lines L1, which means having a large temperature gradient, whereas Fig. 6(b) shows thin isothermal lines L2, which means having a small temperature gradient.

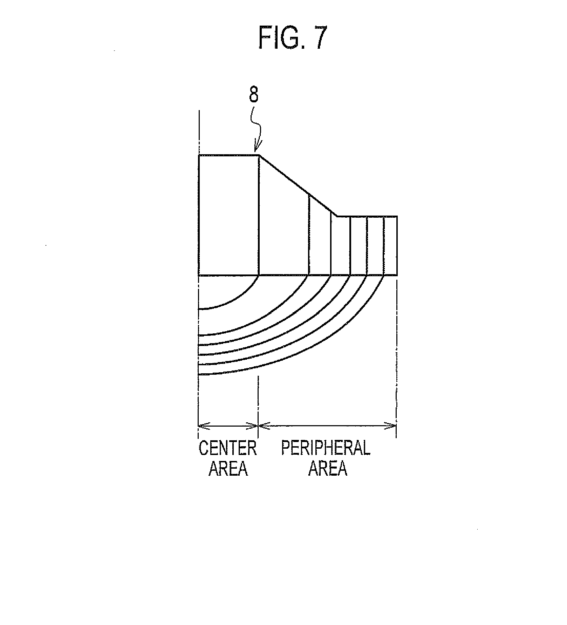

Therefore, in order to reduce the temperature difference between the radial center and the radial outer portion of the lid, the temperature gradient should be reduced by using the thick lid having a constant thickness in the radial direction as in Fig. 6(b). However, in such a case, the temperature gradient at the peripheral portion of the crystal might reach or fall below the lowest value of the temperature gradient for growing a spherical single crystal. Further, it is preferable in growing crystals that the radial center portion (i.e., the center area) of the seed crystal 11 have a smaller temperature gradient than the circumferential portion (i.e., the peripheral area) thereof. For these reasons, as shown in Fig. 7, in the present embodiment, the thickness of the lid 8 at the center area is formed to be larger than the thickness of the lid 8 at the peripheral area so as to provide a small temperature gradient at the radial center portion and a large temperature gradient at the radial outer portion.

### (5) Advantageous Effects

The advantageous effects of the embodiment of the present invention are described below. The present embodiment provides the apparatus 1 for producing a silicon carbide single crystal, comprising the crucible 2 configured to house the seed crystal 11 containing silicon carbide and the raw material for sublimation 10 arranged opposite the seed crystal 11 and used for growing the seed crystal 11. In this apparatus, the crucible 2 includes the crucible body 7 configured to house the raw material for sublimation 10 and the lid 8, 30 configured such that the seed crystal 11 is arranged on the lid 8, 30. The thickness T1, T3 of the lid 8, 30 at the center area thereof corresponding to the radial center portion of the seed crystal 11 is set to be larger than the thickness T2, T4 of the lid 8, 30 at the peripheral area thereof corresponding to a portion located radially outside the radial center portion of the seed crystal 11.

According to this, when the crucible 2 is heated, the temperature difference between the center area and the peripheral area of the lid 8, 30 is decreased. Accordingly, in production of a large-diameter silicon carbide single crystal, a high-quality silicon carbide single crystal having an almost spherical shape can be grown. A description is given below more specifically.

To reduce the temperature difference between the radial center and the radial outer portion of the lid 8, 30, the temperature gradient should be reduced by using a thick lid. However, in such a case, the temperature gradient at the peripheral portion of the crystal might reach or fall below the lowest value of the temperature gradient for growing a spherical single crystal. Further, it is preferable in growing crystals that the radial center portion (i.e., the center area) of the seed crystal 11 have a smaller temperature gradient than the circumferential portion (i.e., the peripheral area) thereof. For these reasons, in the present embodiment, the thickness of the lid 8, 30 at the portion corresponding to the center area of the seed crystal 11 is formed to be larger than the thickness of the lid 8, 30 at the portion corresponding to the peripheral area of the seed crystal 11 so as to provide a small temperature gradient at the radial center portion of the lid 8, 30 and a large temperature gradient at the radial outer portion thereof.

In the present embodiment, in the outer surface of the lid 8, 30, the outer surface 17 of the lid 8, 30 at the center area protrudes more to the outside of the crucible 2 than the outer surface 17 at the peripheral area.

Thereby, with a relatively simple structure, the thickness of the lid 8, 30 at the portion corresponding to the center area of the seed crystal 11 can be formed to be larger than the thickness of the lid 8, 30 at the portion corresponding to the peripheral area of the seed crystal 11.

Further, in the present embodiment, since the heat shield 3 is arranged in accordance with the protruding surface of the lid 8, 30, a gap is unlikely to be generated between the heat shield 3 and the lid 8, 30, providing an efficient heat shield effect.

In the present embodiment, the attachment portion 15 configured such that the seed crystal 11 is attached on the attachment portion 15 is arranged on the inner side of the lid 8, and the sum of the thickness of the lid 8 at the center area and the thickness of the attachment portion 15 is set to be larger than the sum of the thickness of the lid 8 at the portion corresponding to the peripheral area and the thickness of the attachment portion 15.

For this reason, even when the attachment portion 15 for the seed crystal 11 is provided, the thickness of the lid 8 at the portion corresponding to the center area of the seed crystal 11 can be formed to be larger than the thickness of the lid 8 at the portion corresponding to the peripheral area of the seed crystal 11, thereby allowing the temperature gradient to be small at the radial center portion of the lid 8 and to be large at the radial outer portion thereof.

### (6) Other Embodiments

Note that it should not be understood that the description and drawings that constitute part of the disclosure of the embodiment described above limit the present invention. From this disclosure, various alternative embodiments, examples, and operation techniques will be easily found by those skilled in the art.

In the present embodiment, as described using Figs. 2 and 3, the outer surface 17 of the lid 8, 30 is formed into a triangular cross-sectional shape, but the present invention is not limited to this. For example, the surface 17 may be formed into a curved surface projecting upward.

As described above, the present invention naturally includes various embodiments which are not described herein. Accordingly, the technical scope of the present invention should be determined only by the matters to define the invention in the scope of claims regarded as appropriate based on the description.

According to the apparatus for producing a silicon carbide single crystal according to the present invention, a silicon carbide single crystal with a large diameter can be produced without lowering the quality of the silicon carbide single crystal.

## Claims

1. An apparatus (1) for producing a silicon carbide single crystal, including a crucible (2) configured to house a seed crystal containing silicon carbide and a raw material for sublimation (10) arranged opposite the seed crystal (11) and used for growing the seed crystal, wherein
the crucible comprises:
a crucible body (7) configured to house the raw material for sublimation (10), and
a lid (8, 30) configured such that the seed crystal is arranged on the lid (8, 30), **characterised in that**
a thickness (T1, T3) of the lid (8, 30) at a center area thereof corresponding to a radial center portion of the seed crystal (11) is larger than a thickness (T2, T4) of the lid (8, 30) at a peripheral area thereof corresponding to a portion located radially outside the radial center portion of the seed crystal (11), the lid having a peak portion ( 18) corresponding to the radial center portion of the seed crystal (11) and inclines downwardly from the peak portion (18) towards the peripheral area thereof.

2. The apparatus for producing a silicon carbide single crystal according to claim 1, wherein
in an outer surface of the lid (8, 30), an outer surface of the lid at the center area protrudes more to the outside of the crucible than an outer surface thereof at the peripheral area.

3. The apparatus for producing a silicon carbide single crystal according to claim 2, wherein
a heat shield (3) is arranged in accordance with a protruding surface of the lid (8, 30).

4. The apparatus for producing a silicon carbide single crystal according to any one of claims 1 to 3, wherein
an attachment portion (15) configured such that the seed crystal (11) is attached on the attachment portion (15) is arranged on an inner side of the lid (8, 30), and
the sum of the thickness (T1, T3) of the lid (8, 30) at the center area and the thickness of the attachment portion (15) is larger than the sum of the thickness (T2, T4) of the lid (8, 30) at a portion corresponding to the peripheral area and the thickness of the attachment portion (15).

## Patentansprüche

1. Vorrichtung (1) zur Herstellung eines Siliciumcarbid-Einkristalls, einschließlich eines Tiegels (2), der dazu ausgebildet ist, einen Siliciumcarbid enthaltenden Keimkristall und ein Rohmaterial zur Sublimation (10) aufzunehmen, das gegenüber dem Keimkristall (11) angeordnet ist und zum Wachsenlassen des Keimkristalls verwendet wird, wobei der Tiegel umfasst:
einen Tiegelkörper (7), der dazu ausgebildet ist, das Rohmaterial zur Sublimation (10) aufzunehmen, und
einen Deckel (8, 30), der so ausgebildet ist, dass der Keimkristall auf dem Deckel (8, 30) angeordnet ist,
**dadurch gekennzeichnet, dass**
eine Dicke (T1, T3) des Deckels (8, 30) in einem mittleren Bereich desselben, der einem radial mittleren Abschnitt des Keimkristalls (11) entspricht, größer ist als eine Dicke (T2, T4) des Deckels (8, 30) in einem peripheren Bereich desselben, der einem Abschnitt entspricht, der sich radial außerhalb des radial mittleren Abschnitts des Keimkristalls (11) befindet, wobei der Deckel einen höchsten Abschnitt (18) entsprechend dem radial mittleren Abschnitt des Keimkristalls (11) aufweist und sich von dem höchsten Abschnitt (18) in Richtung des peripheren Bereichs desselben nach unten neigt.

2. Vorrichtung zur Herstellung eines Siliciumcarbid-Einkristalls nach Anspruch 1, wobei
in einer äußeren Fläche des Deckels (8, 30), eine äußere Fläche des Deckels im mittleren Bereich mehr nach außerhalb des Tiegels ragt als eine äußere Fläche desselben im peripheren Bereich.

3. Vorrichtung zur Herstellung eines Siliciumcarbid-Einkristalls nach Anspruch 2, wobei
eine Hitzeabschirmung (3) in Übereinstimmung mit einer vorragenden Fläche des Deckels (8, 30) angeordnet ist.

4. Vorrichtung zur Herstellung eines Siliciumcarbid-Einkristalls nach einem der Ansprüche 1 bis 3, wobei
ein Befestigungsabschnitt (15), der so ausgebildet ist, dass der Keimkristall (11) auf dem Befestigungsabschnitt (15) befestigt ist, auf einer Innenseite des Deckels (8, 30) angeordnet ist, und
die Summe der Dicke (T1, T3) des Deckels (8, 30) im mittleren Bereich und der Dicke des Befestigungsabschnitts (15) größer ist als die Summe der Dicke (T2, T4) des Deckels (8, 30) in einem Abschnitt, der dem peripheren Bereich entspricht, und der Dicke des Befestigungsabschnitts (15).

## Revendications

1. Appareil (1) pour la production d'un monocristal de carbure de silicium, incluant un creuset (2) conçu pour accueillir un germe d'inoculation contenant du carbure de silicium et une matière première de sublimation (10) placée face au germe d'inoculation (11) et utilisée pour faire croître le germe d'inoculation,
le creuset comprenant:
un corps de creuset (7) conçu pour accueillir la matière première de sublimation (10) et
un couvercle (8, 30) conçu de sorte que le germe d'inoculation soit placé sur le couvercle (8, 30),
**caractérisé par le fait**
**qu'**une épaisseur (T1, T3) du couvercle (8, 30) au niveau d'une zone centrale de celui-ci correspondant à une partie centrale, dans le sens radial, du germe d'inoculation (11) est supérieure à une épaisseur (T2, T4) du couvercle (8, 30) au niveau d'une zone périphérique de celui-ci correspondant à une partie située radialement à l'extérieur de la partie centrale, dans le sens radial, du germe d'inoculation (11), le couvercle possédant une partie de sommet (18) correspondant à la partie centrale, dans le sens radial, du germe d'inoculation (11) et s'inclinant vers le bas de la partie de sommet (18) vers la zone périphérique du couvercle de celui-ci.

2. Appareil pour la production d'un monocristal de carbure de silicium selon la revendication 1, dans lequel
dans une surface extérieure du couvercle (8, 30), une surface extérieure du couvercle au niveau de la zone centrale fait plus saillie vers l'extérieur du creuset qu'une surface extérieure du couvercle au niveau de la zone périphérique.

3. Appareil pour la production d'un monocristal de carbure de silicium selon la revendication 2, dans lequel
un bouclier thermique (3) est disposé en se conformant à une surface saillante du couvercle (8, 30).

4. Appareil pour la production d'un monocristal de carbure de silicium selon l'une quelconque des revendications 1 à 3, dans lequel
une partie de fixation (15) conçue de sorte que le germe d'inoculation (11) soit fixé sur la partie de fixation (15) est située sur un côté intérieur du couvercle (8, 30) et
la somme de l'épaisseur (T1, T3) du couvercle (8, 30) au niveau de la zone centrale et de l'épaisseur de la partie de fixation (15) est supérieure à la somme de l'épaisseur (T2, T4) du couvercle (8, 30) au niveau d'une partie correspondant à la zone périphérique et de l'épaisseur de la partie de fixation (15).
